# EUROPÄISCHE PATENTSCHRIFT

(11) **EP 1 481 453 B1**
(45) Veröffentlichungstag und Bekanntmachung des Hinweises auf die Patenterteilung: **06.07.2005**
(21) Anmeldenummer: 03709727.6
(22) Anmeldetag: 27.02.2003
(51) Int. Cl.: H01S 5/068, H01S 5/42, H05B 33/08, H01S 5/042

(54) **DIODENLASERANORDNUNG MIT EINER MEHRZAHL VON ELEKTRISCH IN REIHE GESCHALTETEN DIODENLASERN**
DIODE LASER ARRAY COMPRISING A PLURALITY OF ELECTRICALLY SERIES- CONNECTED DIODE LASERS
ENSEMBLE DE DIODES LASER COMPORTANT UNE PLURALITE DE DIODES LASER MONTEES EN SERIE

(30) Priorität: 02.03.2002 DE 10209374
(43) Veröffentlichungstag der Anmeldung: 01.12.2004
(73) Patentinhaber: Rofin-Sinar Laser GmbH, 22093 Hamburg (DE); FRAUNHOFER-GESELLSCHAFT ZUR FÖRDERUNG DER ANGEWANDTEN FORSCHUNG E.V., 80636 München (DE)
(72) Erfinder: DINGER, Reinhold, 21509 Glinde (DE); HOFFMANN, Dieter, 52152 Simmerath (DE); HAAS, Claus, Rüdiger, 52066 Aachen (DE)
(74) Vertreter: Mörtel & Höfner
(86) Internationale Anmeldenummer: PCT/EP2003/002016
(87) Internationale Veröffentlichungsnummer: WO 2003/075423

(56) Entgegenhaltungen:
- EP-A- 0 129 498
- EP-A- 0 878 880
- EP-A- 0 967 590
- DE-A- 10 036 283
- DE-A- 19 841 490
- GB-A- 2 278 717
- US-B1- 6 259 714
- PATENT ABSTRACTS OF JAPAN vol. 2002, no. 05, 3. Mai 2002 (2002-05-03) -& JP 2002 025784 A (ISHIZAWA TAKASHI), 25. Januar 2002 (2002-01-25)
- PATENT ABSTRACTS OF JAPAN vol. 008, no. 221 (E-271), 9. Oktober 1984 (1984-10-09) -& JP 59 103565 A (HITACHI SEISAKUSHO KK), 15. Juni 1984 (1984-06-15)

## Beschreibung

Die Erfindung bezieht sich auf eine Diodenlaseranordnung mit einer Mehrzahl von elektrisch in Reihe geschalteten Diodenlasern.

Hochleistungsdiodenlaser weisen eine Vielzahl möglicher Anwendungsgebiete auf, zu denen unter anderem das Pumpen von Festkörperlasern oder die Materialbearbeitung gehören. Ein Hochleistungsdiodenlaser enthält als laseraktives Element eine quaderförmige Halbleiterstruktur, den sogenannten Diodenlaserbarren, die aus mehreren, nebeneinander angeordneten, elektrisch parallel geschalteten Einzelemittern besteht. Ein solcher Diodenlaserbarren ist typischerweise etwa 10 mm lang, 0,3-2,0 mm breit und 0,1-0,15 mm hoch. Das in den pn-Übergängen erzeugte Laserlicht tritt an der Längsseite des Diodenlaserbarrens aus. Der Diodenlaserbarren ist zwischen einer Grund- und Deckplatte angeordnet, die sowohl zur elektrischen Kontaktierung als auch zur Kühlung dienen. Das Bauelement bestehend aus Diodenlaserbarren, elektrischen Kontakten und Kühlung wird als Diodenlaser bezeichnet. Die typischen optischen Ausgangsleistungen eines solchen Diodenlasers reichen, abhängig von Ausführung und Betriebsart, von ca. 1 W bis zu mehreren 100 W.

Zur weiteren Erhöhung der Ausgangsleistung werden mehrere Diodenlaser geometrisch nebeneinander (=horizontaler Stapel bzw. horizontaler Stack) und/oder übereinander (=vertikaler Stapel bzw. vertikaler Stack) angeordnet.

In einem solchen Stapel werden typischerweise etwa 2 bis zu einigen 100 Diodenlasern elektrisch in Reihe geschaltet. Beim Betrieb des Stapels kann es zum Ausfall einer oder mehrerer der im Stapel angeordneten Diodenlaser, beispielsweise durch spontane Zerstörung des Diodenlaserbarrens bzw. durch Versagen der elektrischen Kontaktierung des Diodenlaserbarrens, kommen. Durch einen solchen hochohmigen Defekt eines einzelnen Diodenlasers wird nun der durch die Reihenschaltung im Stapel fließende Strom unterbrochen, so dass der gesamte Stapel ausfällt. Es muss demzufolge wegen des Ausfalls eines einzigen Diodenlasers der gesamte Stapel ausgetauscht werden. Dies kann zu einem Betriebsausfall der gesamten Laseranlage führen, der mit einem erheblichen wirtschaftlichen Schaden verbunden sein kann. Ein solcher Betriebsausfall könnte prinzipiell durch redundante Anordnungen mit parallelgeschalteten Diodenlaserstapeln vermieden werden. Dies würde jedoch zu erheblich höheren Kosten der Laserquelle führen.

Der Erfindung liegt nun die Aufgabe zu Grunde, eine Diodenlaseranordnung mit einer Mehrzahl von elektrisch in Reihe geschalteten Diodenlasern anzugeben, die auch bei Ausfall eines einzelnen Diodenlasers weiter betrieben werden kann.

Die genannte Aufgabe wird gemäß der Erfindung gelöst mit einer Diodenlaseranordnung mit den Merkmalen des Patentanspruches 1. Da jedem der elektrisch in Reihe geschalteten Diodenlaser zumindest eine Bypassanordnung elektrisch parallel geschaltet ist, die im Normalbetrieb hochohmig ist und den jeweiligen Diodenlaser im Falle eines hochohmigen Defektes niederohmig überbrückt, ist trotz des Ausfalls eines Diodenlasers sichergestellt, dass der Stromfluss durch die übrigen, zu dem ausgefallenen Diodenlaser in Reihe geschalteten Diodenlaser nicht unterbrochen ist. Der gesamte Stapel kann mit nur vernachlässigbarer Leistungsverringerung weiter betrieben werden, so dass gegebenenfalls erforderliche Austausch- oder Reparaturarbeiten auf geplante Stillstandszeiten der mit dieser Diodenlaseranordnung bestückten Laseranlage verschoben werden können.

Optional kann der Diodenlaserstapel mit redundanten Diodenlasern bestückt werden oder eine Leistungsreserve vorgehalten werden, so dass die geplante Nennleistung des Diodenlaserstapels bei Ausfall einzelner Diodenlaser nicht unterschritten wird.

Die Begriffe "niederohmig" und "hochohmig" sind dabei folgendermaßen zu verstehen: Der Widerstand der Bypassanordnung ist im Normalbetrieb so groß, dass die Verlustleistung der Bypassanordnung kleiner ist als die Leistungsaufnahme des Diodenlasers. Vorzugsweise ist die Verlustleistung kleiner als 1/10 der Leistungsaufnahme. Im Überbrückungsfall sinkt der Widerstand der Bypassanordnung auf einen Wert, der die Größenordnung des Widerstandes des Diodenlasers im Normalbetrieb nicht wesentlich überschreitet, vorzugsweise deutlich niedriger als dieser ist. Dabei ist zu beachten, dass der Stromfluß sowohl im Diodenlaser als auch in der Bypassanordnung durch den ohmschen Widerstand und durch eine charakteristische Spannungsschwelle, die durch die Diffusionsspannung (im Fall einer Diodencharakteristik) oder die Zünd- oder Schwellwertspannung (im Fall von Thyristoren oder Transistoren) beeinflusst wird.

In einer weiteren bevorzugten Ausgestaltung ist eine selbstschaltende Bypassanordnung vorgesehen, wobei der Begriff selbstschaltend in dem Sinn zu verstehen ist, dass die Bypassanordnung ohne externe Steuerung zwangsläufig niederohmig wird, wenn die Spannung über dem Diodenlaser einen Schwellwert überschreitet.

Als selbstschaltende Bypassanordnung ist vorzugsweise eine Diode oder eine aus einer Mehrzahl von Dioden aufgebaute Schaltung vorgesehen, die bei einer Spannung im Betriebsbereich des Diodenlasers hochohmig ist.

In einer vorteilhaften Ausgestaltung der Erfindung ist eine selbstschaltende Bypassanordnung vorgesehen, die als steuerbares Schaltelement einen Thyristor, oder eine aus mehreren Thyristoren aufgebaute Schaltung enthält. Der Thyristor ist ein steuerbarer Schalter mit 3 Anschlüssen: Anode und Kathode werden ähnlich einer Diode angeschlossen. Der Thyristor wird leitend, wenn der dritte Anschluß, der zur Steuerung dient, mit einer elektrischen Spannung beaufschlagt wird, die größer ist als eine bauteilspezifische Schwellspannung. Diese Spannung wird vorteilhaft infolge des Spannungsanstiegs bei einem hochohmigen Diodenlaserdefekt an der Anode des Thyristors abgegriffen. Vorteilhaft an dieser Anordnung gegenüber einer einfachen Diode als Bypassanordnung ist deren erheblich niedrigere Verlustleistung. Da eine aus Dioden aufgebaute Bypassanordnung stets eine höhere Verlustleistung als der überbrückte Diodenlaser im Nennbetrieb aufweist, steigt die Leistungsaufnahme des Diodenlaserstapels nach einem Defekt gegenüber dem Nennbetrieb an. Der Thyristorbypass weist dagegen eine niedrigere Verlustleistung als der überbrückte Diodenlaser auf, da die Betriebsspannung des Thyristors deutlich unter die Zündspannung sinken darf, ohne dass er wieder hochohmig wird. Dies führt zu einer erhöhten Lebensdauer des Bypasses, niedrigerem Kühlaufwand und niedrigerer Energieaufnahme.

Besonders günstig ist es, wenn der Thyristor zuverlässig möglichst nahe oberhalb der maximalen Betriebsspannung des Diodenlasers zündet. Das hierzu erforderliche Schwellwertverhalten des Thyristors kann entweder durch geeignete Auslegung des Thyristors oder durch zusätzliche Elemente mit definiertem Schwellverhalten, z.B. durch eine Zenerdiode, erreicht werden.

Anstelle einer selbstschaltenden Bypassanordnung mit einem steuerbaren Schaltelement kann grundsätzlich das zum Schalten des steuerbaren Schaltelements erforderliche Steuersignal, im Falle eines Thyristors die Zündspannung, auch extern zugeführt werden.

Die Verwendung einer extern steuerbaren Bypassanordnung, ermöglicht den Aufbau einer Diodenlaseranordnung, die zusätzliche Diodenlaserbarren oder Diodenlaser enthält, die im Normalbetrieb ungenutzt, d. h. von der Bypassanordnung kurzgeschlossen sind. Im Falle eines Ausfalls eines Diodenlasers kann dieser überbrückt werden und der ungenutzte Diodenlaser durch Öffnen des diesem zugeordneten Schaltelementes zugeschaltet werden, so dass die Diodenlaseranordnung mit gleichen Betriebsparametern und gleicher Ausgangsleistung weiterbetrieben werden kann.

In einer weiteren vorteilhaften Ausgestaltung der Erfindung ist die Bypassanordnung zwischen den Kontakt- und Kühlplatten des Diodenlasers angeordnet, dies ermöglicht eine einfache Integration der Bypassanordnung in den Stapel.

Die Kühlung des Bypass-Elementes erfolgt vorteilhaft auf gleichem Wege wie die Kühlung des zu überbrückenden Diodenlasers.

In einer weiteren vorteilhaften Ausführungsform sind die Bypassanordnung und der Diodenlaser auf einem Chip integriert. Auf diese Weise ist der Fertigungsaufwand bei der Herstellung eines Diodenlaserstapels verringert.

Zur weiteren Erläuterung der Erfindung wird auf die Ausführungsbeispiele der Zeichnung verwiesen. Es zeigen:
Fig. 1 eine Diodenlaseranordnung gemäß der Erfindung in einem elektrischen Prinzipschaltbild,
Fig. 2 ein Ausführungsbeispiel für eine Bypassanordnung,
Fig. 3 ein Diagramm, in dem die Strom-Spannungscharakteristik für einen Diodenlaser und für die Bypassanordnung gemäß Fig. 2 dargestellt ist,
Fig. 4 ein weiteres vorteilhaftes Ausführungsbeispiel für eine selbstschaltende Bypassanordnung,
Fig. 5 den Aufbau einer Diodenlaseranordnung mit einer Mehrzahl von aufeinander in einem Stapel angeordneten und elektrisch in Reihe geschalteten Diodenlasern in einer Prinzipdarstellung.

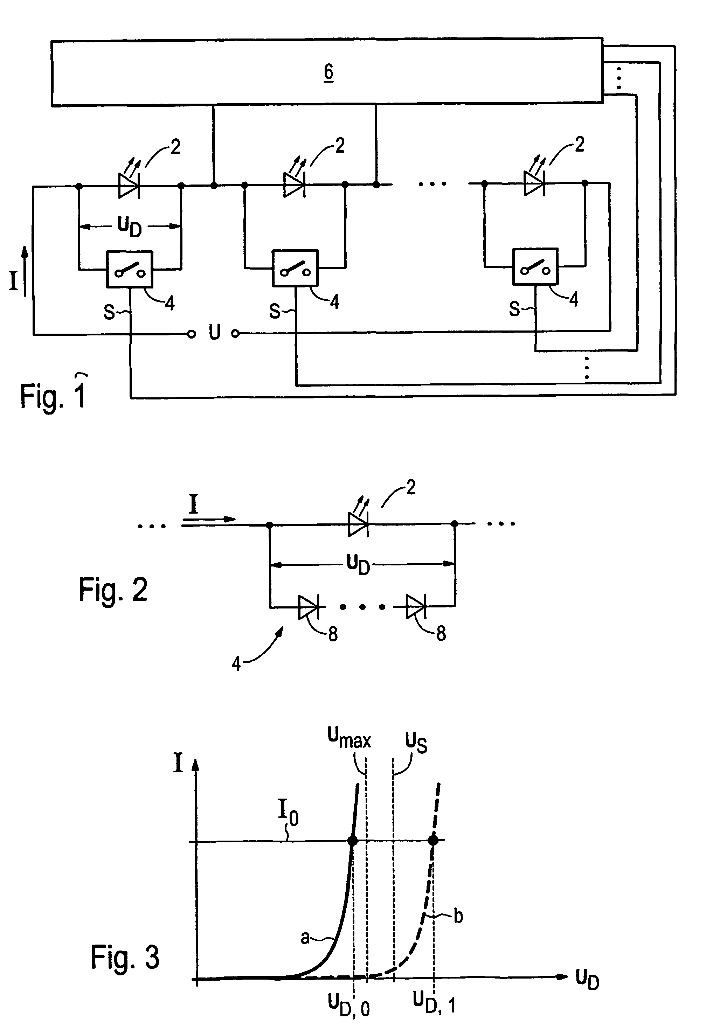

Gemäß Fig 1 sind in einer Diodenlaseranordnung gemäß der Erfindung eine Mehrzahl von Diodenlasern 2 elektrisch in Reihe an eine Spannungsquelle U angeschlossen. Durch den auf diese Weise gebildeten Stapel, der bis zu mehrere hundert Diodenlaser 2 enthalten kann, fließt ein hoher elektrischer Strom I, der typischerweise zwischen 50 und 100 A beträgt. Im Normalbetrieb fällt dabei an jedem Diodenlaser 2 eine Spannung U_{D} ab, die je nach Betriebsstrom und Diodenlaserausführung (z.B. Wellenlänge) bei etwa 2 V liegt. Jedem Diodenlaser 2 ist eine Bypassanordnung 4 parallel geschaltet, die im Normalbetrieb (= nicht geschaltet, symbolisch veranschaulicht durch einen geöffneten Schalter) hochohmig ist, das heißt einen ohmschen Widerstand aufweist, der deutlich größer ist als der ohmsche Widerstand des Diodenlasers 2 bei dessen Normalbetrieb. Die Verlustleistungsaufnahme der nicht geschalteten Bypassanordnung ist somit kleiner als die Nenn-Leistungsaufnahme des Diodenlasers und beträgt vorzugsweise weniger als 1/10 der Leistungsaufnahme des Diodenlasers 2.

Der hochohmige Ausfall eines einzelnen Diodenlasers 2 führt zu einer Unterbrechung des Diodenlaser-Stromkreises, so dass ohne Bypassanordnung 4 die gesamte Betriebsspannung U über dem ausgefallenen Diodenlaser 2 anstehen würde. In einem solchen Fall wird der betroffene Diodenlaser 2 durch die ihm zugeordnete Bypassanordnung 4 niederohmig überbrückt (die Bypassanordnung wird zugeschaltet), so dass der Stromfluss durch die übrigen Diodenlaser 2 in nahezu unveränderter Höhe aufrecht erhalten wird. Unter dem Begriff "niederohmig" ist dabei ein Widerstandswert zu verstehen, der den Widerstand, den der Diodenlaser 2 im Normalbetrieb aufweisen würde, nicht wesentlich überschreitet. Besonders vorteilhaft sind Bypassanordnungen 4, deren Widerstand bei Ausfall des Diodenlasers 2 deutlich niedriger als der Widerstand des Diodenlasers im Normalbetrieb ist.

Als Bypassanordnung 4 ist grundsätzlich jede elektrische Schaltung geeignet, die die Funktion eines steuerbaren Schalters erfüllt, d. h. ein steuerbares Schaltelement, beispielsweise einen Transistor oder einen Thyristor, enthält. Das zur Steuerung erforderliche Steuersignal S kann dabei extern durch eine Steuer- und Auswerteeinrichtung 6 generiert werden, die den an den Diodenlaser 2 jeweils anstehenden Spannungsabfall U_{D} überwacht und den ausgefallenen Diodenlaser 2 oder die ausgefallenen Diodenlaser 2 identifiziert. Grundsätzlich ist es jedoch auch möglich, die Überwachung des korrekten Betriebs des jeweiligen Diodenlasers 2 auch innerhalb der Bypassanordnung 4 durchzuführen, d. h. das zum Steuern des steuerbaren Schaltelementes erforderliche Steuersignal S wird nicht extern sondern intern in der Bypassanordnung 4 generiert. Die Bypassanordnung 4 ist in diesem Fall selbstschaltend.

Mit einer extern steuerbaren Bypassanordnung 4 ist es möglich, gezielt einige der Diodenlaser 2 kurzzuschließen, um bei Ausfall eines oder mehrerer Diodenlaser 2 eine entsprechende Anzahl dieser kurzgeschlossenen Diodenlaser 2 durch Öffnen der Bypassanordnung 4 zuzuschalten.

Gemäß Fig. 2 ist als Bypassanordnung 4 eine aus mehreren Dioden 8 aufgebaute Schaltung vorgesehen. Hierbei handelt es sich um eine aus passiven (nicht steuerbaren) Bauelementen aufgebaute selbstschaltende Bypassanordnung 4, die ohne aktive Bereitstellung eines externen oder internen Steuersignals im Fall eines Hochohmigwerdens des Diodenlasers selbst niederohmig wird. Mit der in der Figur dargestellten Reihenschaltung der Dioden 8 kann auf geeignete Weise eine Strom-Spannungs-Charakteristik erzeugt werden, wie sie in Fig. 3 dargestellt ist. In diesem Diagramm ist der Strom I, der durch das aus Diodenlaser 2 und der dazu parallel geschalteten Bypassanordnung 4 gebildete Bauteil fließt, gegen die Spannung U_{D} aufgetragen. Kurve a zeigt die Strom-Spannungs-Charakteristik eines intakten Diodenlasers. Kurve b gibt die Strom-Spannungs-Charakteristik der aus einer Reihenschaltung von Dioden bestehenden Bypassanordnung 4 an. Die Bypassanordnung 4 muss dabei so dimensioniert sein, dass ihre Schwellspannung U_{S} größer ist als die maximale Betriebsspannung Uₘₐₓ des Diodenlasers. Mit anderen Worten: Die Bypassanordnung 4 ist im Betriebsbereich des Diodenlasers 2 hochohmig und wird bei Spannungen, die diesen Betriebsbereich überschreiten niederohmig. Dadurch entsteht im Betriebsbereich des Diodenlasers 2 in der Bypassanordnung 4 ein nur vernachlässigbarer ohmscher Verlust. Im Ausführungsbeispiel ist der differentielle Widerstand der Bypassanordnung 4 bei Ausfall des Diodenlasers 2 etwa gleich groß. Zur Aufrechterhaltung eines konstanten Stromflusses I₀ durch den Stapel muss die Spannung U_{D} über dem aus defektem Diodenlaser 2 und Bypassanordnung 4 bestehenden Bauteil des Stapels etwas ansteigen. Entsprechend der höheren Potentialdifferenz U_{D,1} > U_{D,0} über dem Bauteil wird somit bei gleichem Strom I₀ im Bauteil eine etwas höhere Leistung umgesetzt. Im Falle einer Regelung der Laserausgangsleistung des Diodenlaseranordnung wird der durch diese fließende Strom I zusätzlich etwas erhöht.

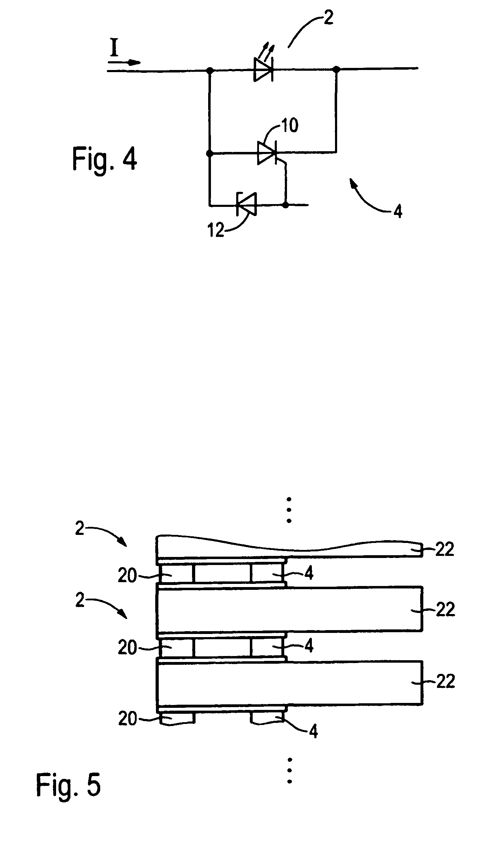

Im Ausführungsbeispiel gemäß Fig. 4 enthält die Bypassanordnung 4 einen der Laserdiode 2 elektrisch parallel geschalteten Thyristor 10 (p-Typ), dessen Gate (Steuerelektrode) über eine Zenerdiode 12 an die Anode des Diodenlasers 2 angeschlossen ist. Die Zenerdiode 12 verhindert ein Zünden des Thyristors 10 im Normalbetrieb. Steigt die Spannung an der Anode des Diodenlasers 2 infolge eines hochohmigen Defektes an und überschreitet die Zenerspannung der Zenerdiode 12, fließt ein Steuerstrom zum Gate des Thyristors 10, der dann zündet und die Laserdiode 2 überbrückt. In diesem Aufbau ist die Bypassanordnung 4 selbstschaltend und die Steuerelektrode des Thyristors 10 wird direkt (Schaltungsaufbau ohne Zenerdiode) oder indirekt über die an der Laserdiode 2 anliegende Anodenspannung beeinflusst. Grundsätzlich kann jedoch das Gate des als steuerbaren Schalter dienenden Thyristors 10 auch über eine externe Steuerspannung geschaltet werden.

Gemäß Fig. 5 sind eine Mehrzahl von elektrisch in Reihe geschalteten Diodenlasern 2 in einem Stapel angeordnet. Im Ausführungsbeispiel bilden die übereinander angeordneten Diodenlaser 2 ein vertikales Stack. Jeder Diodenlaser 2 umfasst einen Diodenlaserbarren 20, der sich zwischen metallischen, vorzugsweise aus Kupfer bestehenden Kontaktplatten 22 befindet, die zugleich als Wärmesenken dienen und insbesondere im Hochleistungsbereich zusätzlich Mikrokanäle aufweisen und durch ein Kühlfluid gekühlt werden. Der Diodenlaserbarren 20 ist zwischen die Kontaktplatten 22 gelötet. Neben dem Diodenlaserbarren 20 ist in den Aufbau die Bypassanordnung 4 zwischen die als p- bzw. n-Kontakt dienenden Kontaktplatten 22 eingelötet.

### Bezugszeichenliste

- 2: Diodenlaser
- 4: Bypassanordnung
- 8: Dioden
- 10: Thyristor
- 12: Zenerdiode
- 20: Diodenlaserbarren
- 22: Kontaktplatten

- U_{S}: Schwellspannung
- U_{D}: Spannung
- Uₘₐₓ: maximale Betriebsspannung
- U: Spannungsquelle
- I: Strom

## Patentansprüche

1. Diodenlaseranordnung mit einer Mehrzahl von elektrisch in Reihe geschalteten Diodenlasern (2), die jeweils einen auf einem Kühl- und Kontaktelement (22) angeordneten Diodenlaserbarren (20) enthalten, und denen jeweils eine Bypassanordnung (4) elektrisch parallel geschaltet ist, die im Normalbetrieb hochohmig ist und den ihr parallel geschalteten Diodenlaser (2) im Falle eines hochohmigen Defektes dieses Diodenlasers (2) niederohmig überbrückt, wobei die Bypassanordnung (4) auf dem Kühl- und Kontaktelement (22) des ihr parallel geschalteten Diodenlasers (2) angeordnet ist.

2. Diodenlaseranordnung nach Anspruch 1, bei der die Bypassanordnung (4) selbstschaltend ist.

3. Diodenlaseranordnung nach Anspruch 2, bei der die Bypassanordnung (4) eine.Diode oder eine Kombination mehrerer Dioden enthält, die bei einer Spannung im Betriebsbereich des Diodenlasers (2) hochohmig ist.

4. Diodenlaseranordnung nach Anspruch 2, bei der die Bypassanordnung (4) einen Thyristor (10) oder eine Kombination von Thyristoren enthält, deren Steuerelektrode direkt oder indirekt über die an der Anode des Diodenlasers (2) anliegende A-nodenspannung beeinflusst wird.

5. Diodenlaseranordnung nach Anspruch 1, dessen Bypassanordnung (4) ein extern steuerbares Schaltelement (5) enthält.

6. Diodenlaseranordnung nach einem der vorhergehenden Ansprüche, bei der die Bypassanordnung (4) zwischen den Kontaktplatten des Diodenlasers (2) angeordnet ist.

7. Diodenlaseranordnung nach einem der vorhergehenden Ansprüche, bei der die Bypassanordnung (4) und der Diodenlaser (2) auf einem Chip integriert sind.

8. Diodenlaseranordnung nach einem der vorhergehenden Ansprüche, bei der die Bypassanordnung (4) und der Diodenlaser (2) einzelne Bauelemente sind.

## Claims

1. Diode laser arrangement having a plurality of diode lasers (2) which are electrically connected in series and each contain a diode laser bar (20) arranged on a cooling and contact element (22), and which each have a bypass arrangement (4) electrically connected in parallel with them, which has a high resistance in normal operation and provides a low-resistance bridge for the diode laser (2) connected in parallel with it in the event of a high-resistance fault in this diode laser (2), the bypass arrangement (4) being arranged on the cooling and contact element (22) of the diode laser (2) which is connected in parallel with it.

2. Diode laser arrangement according to Claim 1, in which the bypass arrangement (4) is self-switching.

3. Diode laser arrangement according to Claim 2, in which the bypass arrangement (4) contains a diode or a combination of a plurality of diodes, which has a high resistance at a voltage in the operating range of the diode laser (2).

4. Diode laser arrangement according to Claim 2, in which the bypass arrangement (4) contains a thyristor (10) or a combination of thyristors whose control electrode is influenced directly or indirectly by means of the anode voltage applied to the anode of the diode laser (2).

5. Diode laser arrangement according to Claim 1, whose bypass arrangement (4) contains an externally controllable switching element (5).

6. Diode laser arrangement according to one of the preceding claims, in which the bypass arrangement (4) is arranged between the contact plates of the diode laser (2).

7. Diode laser arrangement according to one of the preceding claims, in which the bypass arrangement (4) and the diode laser (2) are integrated on one chip.

8. Diode laser arrangement according to one of the preceding claims, in which the bypass arrangement (4) and the diode laser (2) are individual components.

## Revendications

1. Dispositif de lasers à diode comprenant une pluralité de lasers (2) à diode montée en série du point de vue électrique, qui contiennent chacun un barreau (20) de laser à diode, monté sur un élément (22) de refroidissement et de contact, et en parallèle du point de vue électrique avec chacun desquels est monté un dispositif (4) de court-circuit qui est à grande valeur ohmique au cours du fonctionnement normal et qui shunte à basse valeur ohmique le laser (2) à diode avec lequel il est monté en parallèle dans le cas d'un défaut à grande valeur ohmique de ce laser (2) à diode, le dispositif (4) de court-circuit étant monté sur l'élément (22) de refroidissement et de contact du laser (2) à diode avec lequel il est monté en parallèle.

2. Dispositif de laser à diode suivant la revendication 1, dans lequel le dispositif (4) de court-circuit est à déclenchement automatique.

3. Dispositif de laser à diode suivant la revendication 2, dans lequel le dispositif (4) de court-circuit contient une diode ou une combinaison de plusieurs diodes, qui est à grande valeur ohmique pour une tension dans la plage de fonctionnement du laser (2) à diode.

4. Dispositif de laser à diode suivant la revendication 2, dans lequel le dispositif (4) de court-circuit comporte un thyristor (10) ou une combinaison de thyristors, dont l'électrode de commande est influencée directement ou indirectement par l'intermédiaire de la tension anodique s'appliquant à l'anode du laser (2) à diode.

5. Dispositif de laser à diode suivant la revendication 1, dont le dispositif (4) de court-circuit comporte un élément (5) de commande, pouvant être commandé de manière externe.

6. Dispositif de laser à diode suivant l'une des revendications précédentes, dans lequel le dispositif (4) de court-circuit est monté entre les plaques de contact du laser (2) à diode.

7. Dispositif de laser à diode suivant l'une des revendications précédentes, dans lequel le dispositif (4) de court-circuit et le laser (2) à diode sont intégrés sur une puce.

8. Dispositif de laser à diode suivant l'une des revendications précédentes, dans lequel le dispositif (4) de court-circuit et le laser (2) à diode sont des composants individuels.
